Europäisches Patentamt

European Patent Office

Office européen des brevets

(11) Numéro de publication: **0 251 144 B1**

(12) **FASCICULE DE BREVET EUROPEEN**

(45) Date de publication de fascicule du brevet:
**29.01.92**

(51) Int. Cl.⁵: **H03D 13/00**

(21) Numéro de dépôt: **87108994.2**

(22) Date de dépôt: **23.06.87**

(54) **Dispositif comparateur de phase.**

(30) Priorité: **24.06.86 FR 8609113**

(43) Date de publication de la demande:
**07.01.88 Bulletin 88/01**

(45) Mention de la délivrance du brevet:
**29.01.92 Bulletin 92/05**

(84) Etats contractants désignés:
**DE FR GB IT NL**

(56) Documents cités:
**US-A- 4 333 055**
**US-A- 4 520 319**

**ELECTRONICS, vol. 48, no. 17, 21 août 1975, pages 100,101, New York, US; J.C. HAGER, Jr.: "Edge-triggered flip-flops make 360 Celsius phase meter"**

**IEEE TRANSACTIONS ON COMMUNICA- TIONS, vol. COM-30, no. 10, octobre 1982, pages 2364-2375, IEEE, New York, US; R.C. HALGREN et al.: "Improved acquisition in phase-locked loops with sawtooth phase de- tectors"**

(73) Titulaire: **ALCATEL TELSPACE**
**5, rue Noel Pons**
**F-92734 Nanterre(FR)**

(72) Inventeur: **Meuriche, Bernard**
**150 Avenue de Saint Ouen**
**F-75018 Paris(FR)**
Inventeur: **Dehaene, Jean-Pierre**
**30 Place du Bois Corneille**
**F-95220 Herblay(FR)**

(74) Mandataire: **Weinmiller, Jürgen et al**
**Lennéstrasse 9 Postfach 24**
**W-8133 Feldafing(DE)**

Rank Xerox (UK) Business Services

## Description

L'invention se rapporte à un dispositif comparateur de phase.

Certains dispositifs comparateurs de phase de l'art connu possèdent simultanément les trois caractéristiques suivantes :

- A une valeur du déphasage entre les signaux d'entrée correspond une et une seule valeur de la tension de sortie.
- La caractéristique tension de sortie/déphasage entre les signaux d'entrée est linéaire sur une plage de 2 $\pi$, et a la forme d'une dent de scie dissymétrique.
- On peut les réaliser de façon économique, au moyen de deux circuits intégrés du commerce, en technologie rapide de type ECL.

Ces trois caractéristiques sont réunies, par exemple, pour le dispositif décrit dans le brevet US 4520319.

Ce brevet décrit un circuit détecteur de phase destiné à être utilisé dans une boucle de phase. Ce circuit comprend deux bascules bistables de type D. La première bascule reçoit, sur son entrée horloge, un signal de sortie issu d'un oscillateur commandé en tension et sur son entrée "Reset" un signal de référence d'entrée. La seconde bascule reçoit, sur son entrée horloge, le signal de référence d'entrée inversé et sur son entrée "Reset" le signal de sortie issu de l'oscillateur commandé en tension, après que ce signal ait été inversé. Les sorties Q et $\overline{Q}$ de ces deux bascules sont reliées à un diviseur en tension et décalées en amplitude d'une quantité telle que le signal de détection d'erreur de phase soit nul quand le signal de référence d'entrée et le signal de sortie sont en phase.

En plus des trois caractéristiques énumérées ci-dessus le dispositif de l'invention présente deux avantages :

- La sortie du dispositif se fait en un seul point, à la différence d'autres dispositifs connus qui nécessitent l'utilisation d'un pont de résistances ou d'un amplificateur différentiel pour effectuer une sous-traction entre les tensions présentes en deux points du montage.
- Le dispositif de l'invention présente une sensibilité élevée, égale à $\Delta$ V/2 $\pi$ volts par radian, $\Delta$ V représentant la différence entre les niveaux logiques dans la technologie employée.

Cette sensibilité est supérieure à celle des autres dispositifs de l'état de l'art antérieur. Par exemple, le dispositif décrit dans le brevet cité précédemment n'a qu'une sensibilité de $\Delta$ V/4 $\pi$ volts par radian.

Un article intitulé "Edge - triggered flip - flops make 360$^{\circ}$ phase meter" de J.C. Hager paru dans "Electronics" (Vol.48, n$^{\circ}$ 17, 21 août 1975, pages 100 et 101) décrit un dispositif comparateur de phase entre un premier et un second signal logique d'entrée comprenant une première et une seconde bascules D, la sortie dudit dispositif étant la sortie de la première bascule.

L'invention a pour objet un dispositif comparateur de phase entre un premier et un second signal logique d'entrée comprenant une première et une seconde bascules D, la sortie dudit dispositif étant la sortie de la première bascule, ledit dispositif étant caractérisé en ce que la sortie de la deuxième bascule est reliée à l'entrée de la première bascule, l'entrée horloge de cette deuxième bascule étant reliée au niveau bas, le premier signal étant entré, respectivement avant et après inversion, sur les entrées "set" de ces deux bascules, de même le second signal étant entré, respectivement avant et après inversion, sur les entrées "reset" de ces deux bascules, les signaux entrés sur les entrées "set" et "reset" de la première bascule étant entrés dans un circuit logique dont une sortie, donnant un signal qui est le produit logique des deux signaux entrés, est reliée à l'entrée horloge de la première bascule.

Les caractéristiques et avantages de l'invention ressortiront d'ailleurs de la description qui va suivre, à titre d'exemple non limitatif, en référence aux figures annexées sur lesquelles :

- Les figures 1 et 2 représentent deux diagrammes de fonctionnement de l'invention ;
- Les figures 3 illustre une représentation du dispositif de l'invention ;
- Les figures 4 à 7 représentent les signaux obtenus en différents points du dispositif illustré à la figure 3 ;
- La figure 8 illustre une courbe caractéristique du dispositif comparateur de phase de l'invention ;
- Les figures 9, 10 et 11 illustrent des variantes de réalisation du dispositif de l'invention.

Dans ce qui suit :

- Le signe . représente la fonction logique "et"
- Le signe + représente la fonction logique "ou"
- Le signe - représente l'inversion de la variable logique.

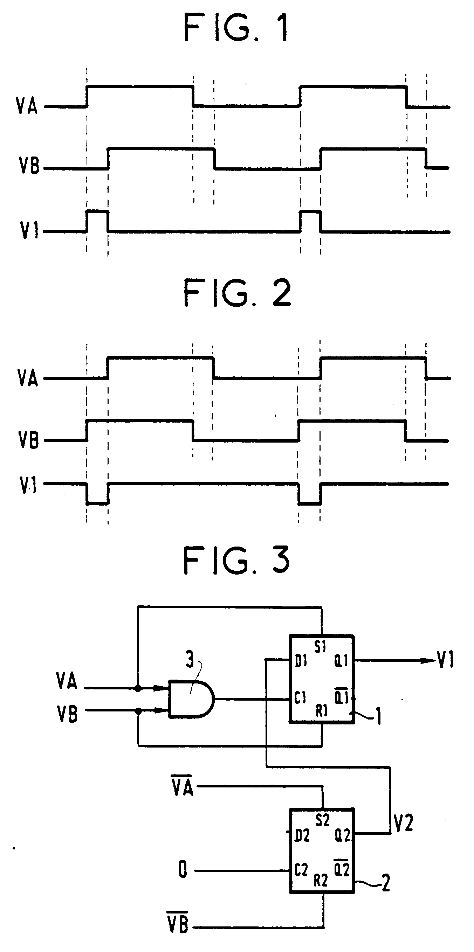

Pour obtenir les deux premières caractéristiques des dispositifs de l'art connu décrites plus haut, il suffit d'obtenir, à la sortie du dispositif, la tension représentée par V1 sur les figures 1 et 2, où VA et VB représentent les signaux d'entrée du comparateur de phase.

Une bascule D, qui agit en fonction des états des signaux présents à ses entrées et non de leurs transitions (en anglais "latch"), peut réaliser cette tâche. La table de vérité d'une telle bascule (par exemple MC1668 du fabricant MOTOROLA) est représentée en fin de description.

Sur cette table de vérité, le signe Ø représente un signal 1 ou 0, indifféremment. On vérifie aisément que le signal de sortie désiré, représenté par V1 aux figures 1 et 2, est bien obtenu au point Q1 du montage de la figure 3, à la condition de placer à l'entrée D de la bascule, lorsque VA et VB sont simultanément au niveau haut, un niveau bas si VA est en avance sur VB, et un niveau haut si VA est en retard sur VB : Appelons V2 un tel signal.

Ce signal V2 est obtenu à la sortie Q2 d'une seconde bascule 2 ayant une table de vérité identique, et connectée comme indiqué à la figure 3 .

Le montage de la figure 3 possède donc les caractéristiques recherchées.

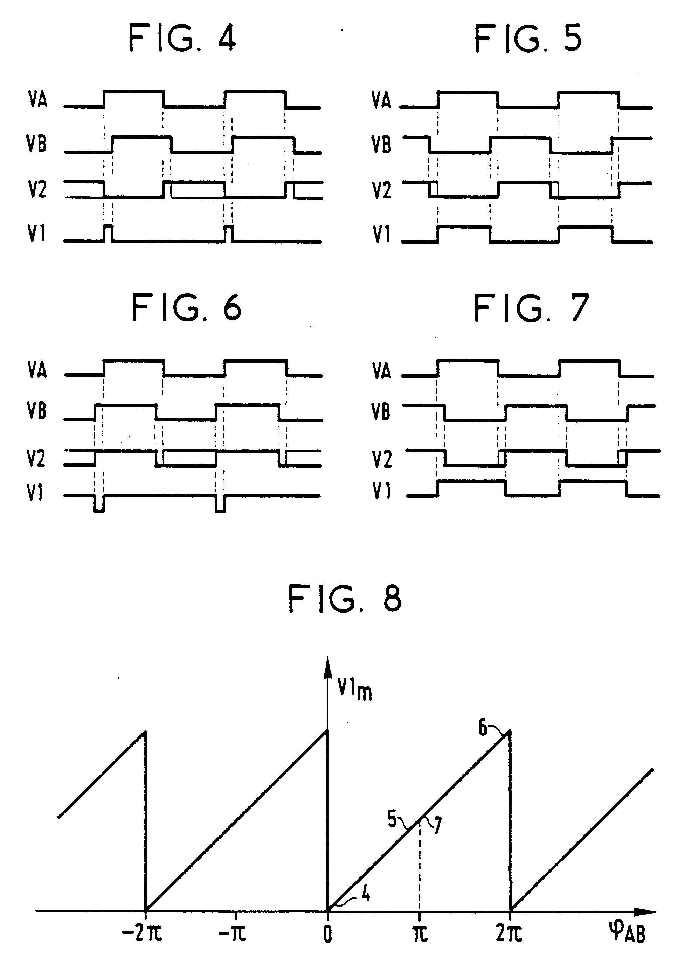

Les figures 4 à 7 représentent les états caractéristiques V1 et V2 des points essentiels Q1 et Q2 du montage de la figure 3, pour quatre valeurs du déphasage relatif des signaux d'entrée VA et VB du comparateur. Ces signaux VA, VB, V1, V2, sont données à la figure 4 pour une faible avance de VA par rapport à VB (voisine de 0 ), à la figure 5 pour une forte avance de VA par rapport à VB (voisine de $\pi$ ), à la figure 6 pour un faible retarde de VA par rapport à VB (voisin de 0), à la figure 7 pour un fort retard de VA par rapport à VB (voisin de $\pi$). Ces valeurs cotées 4, 5, 6, 7 sont aussi représentées sur la figure 8, qui est la courbe caractéristique du comparateur de phase, en forme de dent de scie dissymétrique, périodique et de période 2 $\pi$, donnant la valeur moyenne de V1 : V1m en fonction du déphasage $\phi$ AB de VA par rapport à VB.

- Si on le désire, on peut définir la sortie du montage, tel que représenté à la figure 3, de façon différentielle, entre Q1 et $\overline{Q1}$.

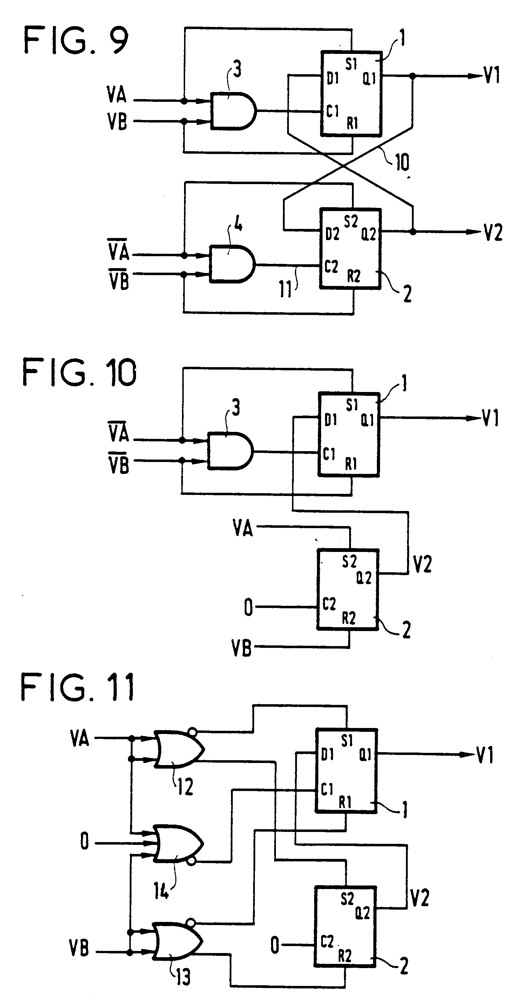

Comme représenté à la figure 9, on peut rendre le montage parfaitement symétrique en ajoutant aux liaisons indiquées à la figure 3 deux liaisons 10 et 11.

En effet, la première liaison 10 ne fait que fixer la tension au point D2, tension à laquelle le montage est insensible.

De plus, ce n'est que lorsque VA et VB sont simultanémant au niveau 1 que le signal de sortie V2 de la seconde bascule a un rôle, et donc que le signal présent à son entrée C2 est utilisé. Or, la seconde liaison 11 fixe bien le niveau à 0 en C2 lorsque VA et VB sont au niveau 1.

Enfin, on peut faire fonctionner le circuit sur $\overline{VA}$ et $\overline{VB}$ comme indiqué figure 10.

Le montage du comparateur de l'invention peut donc être réalisé, comme indiqué à la figure 11, au moyen de deux boîtiers de circuits intégrés en technologie ECL :
- un premier boîtier comprenant les deux bascules, connectées de la même manière qu'à la figure 10.
- un second boîtier comprenant des portes OR/NOR triple, qui fournit les signaux d'entrée convenables aux bascules. En particulier, le signal d'entrée au point C1 est bien égal à VA.VB car, en vertu d'une propriété bien connue des variables logiques binaires : $\overline{VA} . \overline{VB} = \overline{VA + VB}$.

Il est bien entendu que la présente invention n'a été décrite et représentée qu'à titre d'exemple préférentiel et que l'on pourra remplacer ses éléments constitutifs par des éléments équivalents sans, pour autant, sortir du cadre de l'invention.

## Table de vérité :

| Entrées : | "Set" | "Reset" | "Donnée" | "Horloge" | Sortie |
|---|---|---|---|---|---|
| | 0 | 0 | Ø | 0 | état précédent |
| | 1 | 0 | Ø | 0 | 1 |
| | 0 | 1 | Ø | 0 | 0 |
| | 1 | 1 | Ø | 0 | état indéterminé |
| | Ø | Ø | 0 | 1 | 0 |
| | Ø | Ø | 1 | 1 | 1 |

**Revendications**

1.  Dispositif comparateur de phase entre un premier (VA) et un second (VB) signal logique d'entrée comprenant une première (1) et une seconde (2) bascules D, la sortie dudit dispositif étant la sortie (Q1) de la première bascule (1), ledit dispositif étant caractérisé en ce que la sortie (Q2) de la deuxième bascule (2) est reliée à l'entrée (D1) de la première bascule (1), l'entrée horloge (C2) de cette deuxième bascule étant reliée au niveau bas, le premier signal d'entrée (VA) étant entré, respectivement avant et après inversion, sur les entrées "set" de ces deux bascules (1, 2), de même le second signal d'entrée (VB) étant entré, respectivement avant et après inversion, sur les entrées "reset" de ces deux bascules (1, 2), les signaux entrés sur les entrées "set" et "reset" de la première bascule (1) étant entrés dans un circuit logique dont une sortie, donnant un signal qui est le produit logique des deux signaux entrés, est reliée à l'entrée horloge (C1) de la première bascule (1).

2.  Dispositif selon la revendication 1 caractérisé en ce que le circuit logique est une porte ET (3).

3.  Dispositif selon l'une quelconque des revendications précédentes, caractérisé en ce que les signaux entrés sur les entrées "set" et "reset" de la première bascule (1) sont les signaux d'entrée (VA, VB), en ce que la sortie (Q1) de la première bascule (1) est reliée à l'entrée (D2) de la deuxième bascule (2), et en ce qu'une porte ET, qui reçoit en entrée les signaux d'entrée (VA, VB) après inversion est reliée à l'entrée horloge (C2) de la deuxième bascule (2).

4.  Dispositif selon l'une quelconque des revendications précédentes caractérisé en ce que les signaux entrés sur les entrées "set" et "reset" de la première bascule (1) sont les signaux d'entrée inversés obtenus sur les deux premières sorties inversées de deux portes OR/NOR triple (12, 13) dont les deux secondes sorties non inversées sont reliées aux entrées "set" et "reset" de la deuxième bascule (2), la première (12) de ces deux portes OR/NOR recevant sur ses entrées le premier signal d'entrée (VA), et la deuxième porte (13) recevant sur ses entrées le deuxième signal d'entrée (VB), une troisième porte OR/NOR triple (14) recevant sur ses entrées le premier signal d'entrée (VA), le deuxième signal d'entrée (VB) et le niveau logique bas, la sortie de cette troisième porte (14), qui délivre un signal produit logique des deux signaux d'entrée inversés, étant reliée à l'entrée horloge (C1) de la première bascule (1).

**Claims**

1.  A phase comparator circuit for comparing a first input logic signal (VA) with a second input logic signal (VB), the circuit comprising first and second D-type bistables (1, 2), with the output of said circuit being constituted by the output (Q1) of the first bistable (1), said circuit being characterized in that the output (Q2) of the second bistable (2) is connected to the input (D1) of the first bistable (1), the clock input (C2) of said second bistable being connected to low level, the first input signal (VA) being applied respectively before and after inversion to the set inputs of the two bistables (1, 2), with the second input signal (VB) being likewise input respectively before and after inversion to the reset inputs of said two bistables (1, 2), the signals input to the set and reset inputs of the first bistable (1) being input to a logic circuit having an output that provides a signal which is the logical product of its two input signals and which is connected to the clock input (C1) of the first bistable (1).

2.  A circuit according to claim 1, characterized in that the logic circuit is an AND gate (3).

3.  A circuit according to any preceding claim, characterized in that the signals input to the set and reset inputs of the first bistable (1) are the input signals (VA, VB), in that the output (Q1) from the first bistable (1) is connected to the input (D2) of the second bistable (2), and in that an AND gate which receives the input signals (VA, VB) at its inputs after inversion is connected to the clock input (C2) of the second bistable (2).

4.  A circuit according to any preceding claim, characterized in that the signals input to the set and reset inputs of the first bistable (1) are the inverted input signals obtained from two first inverting outputs of two triple OR/NOR gates (12, 13) whose non-inverting second outputs are connected to the set and reset inputs respectively of the second bistable (2), the first (12) of said two OR/NOR gates receiving the first input signal (VA) on its inputs and the second gate (13) receiving the second input signal (VB) on its inputs, a third triple OR/NOR gate (14) receiving the first input signal (VA), the second input signal, and a logic low level on its inputs, the output from the third gate (14) which delivers a logical product signal of its two inverted input signals being connected to the clock input (C1) of the first bistable (1).

**Patentansprüche**

1. Phasenkomparator zum Vergleich zwischen einem ersten (VA) und einem zweiten logischen Eingangssignal (VB), mit einer ersten (1) und einer zweiten D-Kippstufe D (2), wobei als Ausgang des Komparators der Ausgang (Q1) der ersten Kippstufe (1) dient, dadurch gekennzeichnet, daß der Ausgang (Q2) der zweiten Kippstufe (2) mit dem Eingang (D1) der ersten Kippstufe (1) verbunden ist, der Takteingang (C2) dieser zweiten Kippstufe mit dem niedrigen Pegel verbunden ist, das erste Eingangssignal (VA) vor bzw. nach der Invertierung an die Setz-Eingänge dieser beiden Kippstufen (1, 2) angelegt wird, und gleichermaßen das zweite Eingangssignal (VB) vor bzw. nach Invertierung an die Rücksetz-Eingänge dieser beiden Kippstufen (1, 2) angelegt wird, wobei die an die Setz- und Rücksetz-Eingänge der ersten Kippstufe (1) angelegten Signale in einen logischen Kreis eingeführt werden, von dem ein Ausgang, der ein Signal abgibt, das das logische Produkt der beiden angelegten Signale ist, mit dem Takteingang (C1) der ersten Kippstufe (1) verbunden ist.

2. Komparator nach Anspruch 1, dadurch gekennzeichnet, daß der logische Kreis ein UND-Glied (3) ist.

3. Komparator nach einem beliebigen der vorhergehenden Ansprüche, dadurch gekennzeichnet, daß die an die Setz- und Rücksetz-Eingänge der ersten Kippstufe (1) angelegten Signale die Eingangssignale (VA, VB) sind, daß der Ausgang (Q1) der ersten Kippstufe (1) mit dem Eingang (D2) der zweiten Kippstufe (2) verbunden ist, und daß ein UND-Glied, das am Eingang die Eingangssignale (VA, VB) nach Invertierung empfängt, mit dem Takteingang (C2) der zweiten Kippstufe (2) verbunden ist.

4. Komparator nach einem beliebigen der vorhergehenden Ansprüche, dadurch gekennzeichnet, daß die an die Setz- und Rücksetz-Eingänge der ersten Kippstufe (1) angelegten Signale die invertierten Eingangssignale sind, die an den ersten beiden invertierten Ausgängen zweier dreifacher OR/NOR-Glieder (12, 13) erhalten werden, deren beide zweite nicht invertierte Ausgänge mit den Setz- und Rücksetz-Eingängen der zweiten Kippstufe (2) verbunden sind, wobei das erste (12) dieser beiden OR/NOR-Glieder an seinen Eingängen das erste Eingangssignal (VA) empfängt und das zweite Glied (13) an seinen Eingängen das zweite Eingangssignal (VB) empfängt, während ein drittes dreifaches OR/NOR-Glied (14) an seinen Eingängen das erste Eingangssignal (VA), das zweite Eingangssignal (VB) und den niedrigen logischen Pegel empfängt, wobei der Ausgang dieses dritten Glieds (14), der ein logisches Produkt der beiden invertierten Eingangssignale darstellendes Signal liefert, mit dem Takteingang (C1) der ersten Kippstufe (1) verbunden ist.

# FIG. 1

# FIG. 2

# FIG. 3

# FIG. 4

# FIG. 5

# FIG. 6

# FIG. 7

# FIG. 8

# FIG. 9

# FIG. 10

# FIG. 11